# FASCICULE DE BREVET EUROPEEN

(11) **EP 1 633 911 B1**
(45) Date de publication et mention de la délivrance du brevet: **12.09.2007**
(21) Numéro de dépôt: 04742653.1
(22) Date de dépôt: 05.05.2004
(51) Int. Cl.: C30B 25/18

(54) **PROCEDE DE FORMATION D’UNE COUCHE DE CARBURE DE SILICIUM SUR UNE TRANCHE DE SILICIUM**
VERFAHREN ZUR HERSTELLUNG EINER SCHICHT AUS SILICIUM KARBID AUF EINER SILICIUMSCHEIBE
METHOD OF FORMING A LAYER OF SILICON CARBIDE ON A SILICON WAFER

(30) Priorité: 05.05.2003 FR 0305453
(43) Date de publication de la demande: 15.03.2006
(73) Titulaire: Centre National De La Recherche, 75794 Paris Cedex 16 (FR)
(72) Inventeur: LEYCURAS, André, F-06560 Valbonne (FR)
(74) Mandataire: Bredema
(86) Numéro de dépôt international: PCT/FR2004/001091
(87) Numéro de publication internationale: WO 2004/099471

(56) Documents cités:
- EP-A- 1 143 033
- US-B1- 6 416 578
- CHASSAGNE T ET AL: "HOW TO GROW UNSTRAINED 3C-SIC HETEROEPITAXIAL LAYERS ON Si (100) SUBSTRATES" MATERIALS SCIENCE FORUM, AEDERMANNSFDORF, CH, vol. 353-356, 2001, pages 155-158, XP008026449 ISSN: 0255-5476 cité dans la demande
- PATENT ABSTRACTS OF JAPAN vol. 013, no. 169 (C-587), 21 avril 1989 (1989-04-21) & JP 63 319294 A (SHARP CORP), 27 décembre 1988 (1988-12-27)
- PATENT ABSTRACTS OF JAPAN vol. 1998, no. 10, 31 août 1998 (1998-08-31) & JP 10 125905 A (DENSO CORP), 15 mai 1998 (1998-05-15)
- PATENT ABSTRACTS OF JAPAN vol. 013, no. 101 (C-574), 9 mars 1989 (1989-03-09) & JP 63 277596 A (SHARP CORP), 15 novembre 1988 (1988-11-15)
- PATENT ABSTRACTS OF JAPAN vol. 013, no. 084 (C-572), 27 février 1989 (1989-02-27) & JP 63 270398 A (SHARP CORP), 8 novembre 1988 (1988-11-08)

## Description

La présente invention concerne la croissance de carbure de silicium sur un substrat de silicium (SiC/Si).

Actuellement la croissance de carbure de silicium sur un substrat de silicium constitue un moyen privilégié d'obtention de couches de SiC cubique de grandes dimensions. Les avantages du silicium comme substrat pour la croissance de SiC et/ou d'autres matériaux résident dans son faible coût, sa disponibilité en grandes dimensions, son aptitude à former directement une couche de 3C SiC par carburation. Les inconvénients des substrats de silicium pour la croissance du SiC résultent notamment de l'écart entre les paramètres de maille et de l'écart entre les coefficients de dilatation thermique de Si et SiC. Ceci conduit à une qualité cristalline médiocre mais surtout à l'établissement de fortes contraintes résiduelles quand le substrat est ramené de la température de croissance à la température ambiante, d'où il résulte une forte courbure du substrat.

En fait, la qualité cristalline est suffisante pour un grand nombre d'applications telles que la réalisation de capteurs de pression, de température ou de débit ainsi que certains dispositifs électroniques. Par contre la courbure peut être si élevée qu'elle rend impossible l'utilisation des techniques habituelles de photolithographie nécessaires pour l'exploitation industrielle de ces couches et d'autant plus quand la dimension des substrats augmente, alors que l'utilisation de tranches de silicium de grands diamètres, couramment égaux ou supérieurs à 20 cm, est actuellement la règle dans les processus de fabrication industriels.

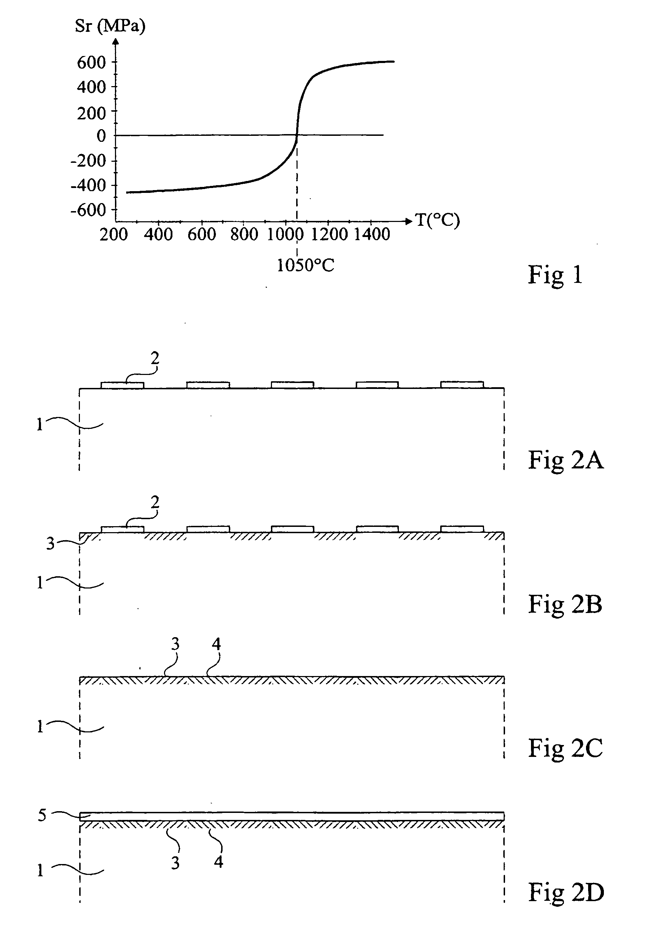

T. Chassagne et al ont montré, dans un article publié dans Materials Science Forum, Vol. 353-356 (2001), pp. 155-158 que, selon la température de carburation du substrat, la couche de SiC peut être soit en compression soit en extension. Ils proposent dans la conclusion de leur article de réaliser des couches de SiC non contraintes par une sélection de cette température de carburation. Toutefois la courbe illustrée en figure 2 de l'article susmentionné et reproduite dans la figure 1 ci-jointe indique que la transition entre compression et extension se fait dans un intervalle extrêmement étroit et il peut être difficile dans le cadre d'un processus industriel et reproductible de se placer dans des conditions dans lesquelles la contrainte serait nulle.

On ne dispose donc toujours pas d'un procédé simple permettant la croissance d'une couche de carbure de silicium sur un substrat de silicium en évitant ou en réduisant notablement la courbure de la structure obtenue.

Un objet de la présente invention est de proposer un tel procédé.

La présente invention vise également une structure comprenant une couche de carbure de silicium sur un substrat de silicium présentant une courbure nulle ou du moins suffisamment faible pour être compatible avec les possibilités technologiques courantes.

Pour atteindre ces objets, la présente invention prévoit un procédé de formation d'une couche de carbure de silicium sur une tranche de silicium, comprenant les étapes suivantes consistant à déposer un masque anti-carburation sur la plaquette selon un motif sensiblement en damier ; procéder à une étape de carburation dans des conditions telles que la contrainte résiduelle soit de type en extension, respectivement en compression ; éliminer le masque ; et procéder à une étape de carburation dans des conditions telles que la contrainte résiduelle soit de type en compression, respectivement en extension.

Selon un mode de réalisation de la présente invention, le procédé comprend en outre, après les étapes de carburation, une étape de croissance épitaxiale d'une couche de carbure de silicium.

Selon un mode de réalisation de la présente invention, l'une des étapes de carburation est effectuée à une température inférieure à 1000°C et l'autre étape de carburation est effectuée à une température supérieure à 1100°C.

Selon un mode de réalisation de la présente invention, l'une des étapes de carburation est effectuée à une température inférieure à 950°C et l'autre étape de carburation est effectuée à une température supérieure à 1150°C.

Selon un mode de réalisation de la présente invention, au moins la première étape de carburation est effectuée jusqu'à saturer en carbone la surface supérieure des zones carburées.

Selon un mode de réalisation de la présente invention, le masque est constitué d'oxyde de silicium.

La présente invention prévoit aussi une plaquette de silicium recouverte de carbure de silicium sur laquelle alternent des zones dans lesquelles la contrainte résiduelle entre le carbure de silicium et le silicium est une contrainte en compression et des zones dans lesquelles la contrainte résiduelle entre le carbure de silicium et le silicium est une contrainte en extension.

Selon un mode de réalisation de la présente invention, les zones alternées sont disposées selon un motif sensiblement en damier.

Selon un mode de réalisation de la présente invention, les contraintes présentent une anisotropie et les zones alternées sont asymétriques.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente la contrainte résiduelle en fonction de la température de carburation telle que publiée dans l'article susmentionné de T. Chassagne et al ; et
les figures 2A à 2D illustrent des étapes successives d'un procédé selon la présente invention.

De façon générale, la présente invention propose de partager la surface d'un substrat de silicium en deux types de zones. Sur un type de zone la carburation sera faite selon un procédé provoquant des contraintes résiduelles en compression, et sur l'autre type de zone selon un procédé provoquant des contraintes résiduelles en extension. On entend ici par "contrainte résiduelle", la contrainte apparaissant quand le substrat est ramené de la température de croissance à la température ambiante.

La superficie d'une zone doit être petite par rapport à la superficie du substrat de manière que la contrainte résiduelle moyenne soit homogène sur tout le substrat. La surface et la forme des zones de chaque type sont déterminées de manière que la contrainte totale en extension des zones en extension soit contrebalancée par la contrainte totale en compression des zones en compression. La valeur absolue de la contrainte en extension est généralement assez proche de la valeur absolue de la contrainte en compression ce qui fait qu'avec un substrat préparé pour obtenir une répartition en damier de carrés en compression alternés avec des carrés en extension de même surface, on obtient des résultats satisfaisants. Si ces contraintes sont différentes, on pourra prévoir une structure en damier déformé dans laquelle les carrés d'un premier type seront complètement séparés les uns des autres par un fond continu de l'autre type.

Dans le cas d'une anisotropie de courbure importante, par exemple si le substrat est désorienté par rapport à un plan cristallographique de bas indices, les zones élémentaires, ou les zones de l'un des deux types, peuvent avantageusement être carrées, rectangulaires, circulaires ou ovales de manière à compenser les contraintes dans chaque direction.

Les dimensions des zones élémentaires peuvent être adaptées à celles des composants pour lesquels la structure a été réalisée de manière à tirer le meilleur parti de celle-ci. Le composant peut éventuellement tirer parti de la présence des deux types de contraintes au niveau de sa partie active et/ou de celui de sa partie passive, par exemple une partie de zone active en tension entourée d'une partie de zone passive en compression qui, soit équilibre la contrainte de la zone active, soit sert de support à des pistes de circuit électrique. Cela peut conduire à des formes plus complexes, éventuellement avec des zones élémentaires concentriques.

les figures 2A à 2D sont des vues en coupe schématiques illustrant des étapes successives de mise en oeuvre de la présente invention.

Comme l'illustre la figure 2A, on part d'un substrat de silicium 1 recouvert d'un masque 2 ayant une configuration en damier ou de type damier, comme cela a été décrit précédemment.

Ensuite, comme l'illustre la figure 2B, on procède à une carburation du substrat de façon à obtenir des zones carburées 3 dans les régions non recouvertes du masque 2. Le masque 2 peut par exemple être constitué d'une couche mince de SiO₂, d'une épaisseur d'environ 100 nm, ou de tout autre matériau, tel que Si₃N₄, susceptible d'empêcher les zones qu'il recouvre d'être carburées.

Pour cette étape de carburation, on se placera dans une plage de températures telle que la contrainte résiduelle qui serait provoquée lors d'un refroidissement du substrat en cas de dépôt d'une couche homogène, entraîne une contrainte résiduelle par compression ou par extension. Si on se place dans les conditions indiquées dans l'article susmentionné, on choisira une plage de température nettement supérieure ou nettement inférieure à 1050°C. On se placera par exemple en dessous de 1000°C et de préférence de 950°C ou au dessus de 1100°C et de préférence de 1150°C. On notera que l'on pourra choisir d'autres types de conditions et que l'important est de se placer nettement d'un côté ou de l'autre des conditions limites dans lesquelles la carburation entraîne une contrainte résiduelle en compression ou en extension.

Ensuite, comme l'illustre la figure 2C, on élimine le masque 2 et l'on procède à une nouvelle étape de carburation en se plaçant de l'autre côté des conditions limites susmentionnées, c'est-à-dire, que si les régions 3 résultent d'une carburation provoquant une contrainte résiduelle en compression/extension, la carburation des zones 4 entraînera des contraintes résiduelles de type extension/compression.

Si la première étape de carburation a été réalisée dans des conditions telles que l'on ait une saturation de carbone en surface, lors de l'étape de carburation suivante, les zones déjà carburées ne sont pas affectées.

Ensuite, comme l'illustre la figure 2D, on procède de préférence à une croissance par épitaxie d'une couche 5 de carbure de silicium, de sorte que l'épaisseur totale de la couche de carbure de silicium comprenant les zones carburées et la couche épitaxiale ait une valeur souhaitée. De façon classique, cette épitaxie est réalisée à une température supérieure à 1150°C. Toutefois, cette épitaxie se développera avec les mêmes caractéristiques pour le SiC que celles des régions sous-jacentes, c'est-à-dire que les parties de la couche épitaxiale formées au-dessus des zones carburées provoquant une contrainte résiduelle en extension provoqueront une contrainte résiduelle en extension et que les parties de la couche épitaxiale formées au-dessus des zones carburées provoquant une contrainte résiduelle en compression provoqueront également une contrainte résiduelle en compression.

La couche et le substrat sont alors prêts à être utilisés pour la fabrication de composants. On pourra notamment former sur le carbure de silicium une couche épitaxiale d'un nitrure d'élément III.

Bien entendu, la présente invention est susceptible de diverses variantes et modifications qui apparaîtront à l'homme de l'art. En particulier, l'homme de l'art pourra choisir la répartition des zones de divers types et les conditions de carburation et d'épitaxie.

## Revendications

1. Procédé de formation d'une couche de carbure de silicium (3, 4) sur une tranche de silicium (1), **caractérisé en ce qu'**il comprend les étapes suivantes :
déposer un masque anti-carburation (2) sur la plaquette selon un motif sensiblement en damier ;
procéder à une étape de carburation dans des conditions telles que la contrainte résiduelle soit de type en extension, respectivement en compression ;
éliminer le masque ;
procéder à une étape de carburation dans des conditions telles que la contrainte résiduelle soit de type en compression, respectivement en extension.

2. Procédé selon la revendication 1, comprenant en outre, après les étapes de carburation, une étape de croissance épitaxiale d'une couche de carbure de silicium (5).

3. Procédé selon la revendication 1, dans lequel l'une des étapes de carburation est effectuée à une température inférieure à 1000°C et l'autre étape de carburation est effectuée à une température supérieure à 1100°C.

4. Procédé selon la revendication 1, dans lequel l'une des étapes de carburation est effectuée à une température inférieure à 950°C et l'autre étape de carburation est effectuée à une température supérieure à 1150°C.

5. Procédé selon la revendication 1, dans lequel au moins la première étape de carburation est effectuée jusqu'à saturer en carbone la surface supérieure des zones carburées.

6. Procédé selon la revendication 1, dans lequel le masque est constitué d'oxyde de silicium.

7. Plaquette de silicium (1) recouverte de carbure de silicium (3, 4) sur laquelle alternent des zones dans lesquelles la contrainte résiduelle entre le carbure de silicium et le silicium est une contrainte en compression et des zones dans lesquelles la contrainte résiduelle entre le carbure de silicium et le silicium est une contrainte en extension.

8. Plaquette de silicium selon la revendication 7, dans laquelle les zones alternées sont disposées selon un motif sensiblement en damier.

9. Plaquette de silicium selon la revendication 8, dans laquelle les contraintes présentent une anisotropie et les zones alternées sont asymétriques.

## Claims

1. Method of forming a layer of silicon carbide (3, 4) on a silicon wafer (1), **characterised in that** it comprises the following steps:
depositing an anti-carburising mask (2) on the wafer following a substantially grid-like pattern;
performing a carburising step under conditions such that the residual stress consists of extension and compression respectively;
removing the mask;
performing a carburising step under conditions such that the residual stress consists of compression and extension respectively.

2. Method according to claim 1, also comprising, after the carburising steps, a step of epitaxial growth of a layer of silicon carbide (5).

3. Method according to claim 1, wherein one of the carburising steps is carried out at a temperature lower than 1000°C and the other carburising step is carried out at a temperature higher than 1100°C.

4. Method according to claim 1, wherein one of the carburising steps is carried out at a temperature lower than 950°C and the other carburising step is carried out at a temperature higher than 1150°C.

5. Method according to claim 1, wherein at least the first carburising step is carried out until saturating the upper surface of the carburised areas with carbon.

6. Method according to claim 1, wherein the mask is made from silicon oxide.

7. Silicon wafer (1) covered with silicon carbide (3, 4) with alternating areas in which the residual stress between the silicon carbide and the silicon is compressive stress and areas in which the residual stress between the silicon carbide and the silicon is extensive stress.

8. Silicon wafer according to claim 7, wherein the alternating areas are disposed in a substantially grid-like pattern.

9. Silicon wafer according to claim 8, wherein the stresses are anisotropic and the alternating areas are asymmetric.

## Patentansprüche

1. Verfahren zur Bildung einer Siliziumkarbidschicht (3, 4) auf einem Siliziumplättchen (1), **dadurch gekennzeichnet, daß** es folgende Phasen umfaßt:
- Aufbringen einer Maske gegen die Aufkohlung (2) auf das Plättchen nach einem erkennbaren Schachbrettmuster;
- Durchführen einer Aufkohlungsphase unter solchen Bedingungen, daß die Restauflage vom Typ einer Dehnung beziehungsweise einer Verdichtung ist;
- Entfernen der Maske;
- Durchführen einer Aufkohlungsphase unter solchen Bedingungen, daß die Restauflage vom Typ einer Verdichtung beziehungsweise einer Dehnung ist.

2. Verfahren nach Anspruch 1, das außerdem nach den Aufkohlungsphasen eine Phase mit epitaktischem Wachstum einer Siliziumkarbidschicht (5) umfaßt.

3. Verfahren nach Anspruch 1, bei dem eine der Aufkohlungsphasen bei einer Temperatur von unter 1.000°C abläuft, und die andere Aufkohlungsphase bei einer Temperatur von über 1.100°C abläuft.

4. Verfahren nach Anspruch 1, bei dem eine der Aufkohlungsphasen bei einer Temperatur von unter 950°C abläuft, und die andere Aufkohlungsphase bei einer Temperatur von über 1.150°C abläuft.

5. Verfahren nach Anspruch 1, bei dem mindestens die erste Aufkohlungsphase abläuft, bis die obere Fläche der gekohlten Zonen mit Kohlenstoff gesättigt ist.

6. Verfahren nach Anspruch 1, bei dem die Maske aus Siliziumoxid besteht.

7. Siliziumplättchen (1), das mit Silizumkarbid (3, 4) bedeckt ist, auf dem die Zonen, in denen die Restauflage zwischen dem Siliziumkarbid und dem Silizium eine Auflage in Verdichtung ist, und die Zonen, in denen die Restauflage zwischen dem Siliziumkarbid und dem Silizium eine Auflage in Dehnung ist.

8. Siliziumplättchen nach Anspruch 7, bei dem die abwechselnden Zonen nach einem erkennbaren Schachbrettmuster angeordnet sind.

9. Siliziumplättchen nach Anspruch 8, bei dem die Auflagen eine Anisotropie aufweisen und die abwechselnden Zonen asymmetrisch sind.
